# EUROPEAN PATENT APPLICATION

(11) **EP 4 701 371 A1**
(43) Date of publication of application: **25.02.2026**
(21) Application number: 25196953.1
(22) Date of filing: 20.08.2025
(51) Int. Cl.: H10F 39/00

(54) **IMAGE SENSING APPARATUS**

(30) Priority: 22.08.2024 KR 20240113085
(71) Applicant: LX Semicon Co., Ltd., Daejeon 34027 (KR)
(72) Inventor: KIM, Jongman, Daejeon 34027 (KR); JANG, Hoon, Daejeon 34027 (KR)
(74) Representative: Goddar, Heinz J.

(57) **Abstract**

An image sensing apparatus according to an aspect of the present disclosure, which enables dynamic range realization in an image sensor with small-sized pixels, includes a first photodiode having a first area, a first floating diffusion node in which charges generated by the first photodiode are stored, a first charge transfer transistor configured to transfer the charges generated by the first photodiode to the first floating diffusion node, a second photodiode having a second area smaller than the first area, a second floating diffusion node in which charges generated by the second photodiode are stored, and a second charge transfer transistor configured to transfer the charges generated by the second photodiode to the second floating diffusion node, wherein an image signal at a first illuminance is generated using an output signal based on the charges generated by the first photodiode, and an image signal at a second illuminance higher than the first illuminance is generated using an output signal based on the charges generated by the second photodiode.

## Description

### CROSS-REFERENCE TO RELATED APPLICATIONS

This application claims the benefit of the Korean Patent Application No. 10-2024-0113085 filed on August 22, 2024 which is hereby incorporated by reference as if fully set forth herein.

### BACKGROUND

### Field of the Invention

The present specification relates to an image sensing apparatus.

### Discussion of the Related Art

Image sensors are devices that convert optical images into electrical signals. Recently, with the development of the computer and communications industries, the demand for image sensors has been increasing in various fields, such as digital cameras, camcorders, personal communication systems (PCS), gaming devices, security cameras, medical micro-cameras, and robots.

The image sensor generates an image of an object using a photoelectric conversion element that reacts according to the intensity of light reflected from the object. With the development of complementary metal-oxide semiconductor (CMOS) technology, CMOS image sensors using CMOSs are becoming widely used.

Recently, as image sensors have been incorporated into various devices, the demand has been increasing for image sensors that provide enhanced high dynamic range (HDR) and signal-to-noise ratio (SNR) characteristics under both low- and high-illuminance conditions.

### SUMMARY

The present disclosure is directed to providing an image sensing apparatus that enables dynamic range realization in an image sensor with small-sized pixels.

The present disclosure is also directed to providing an image sensing apparatus capable of improving dark current characteristics.

The present disclosure is also directed to providing an image sensing apparatus capable of enhancing charge transfer characteristics.

According to an aspect of the present disclosure, there is provided an image sensing apparatus including a first photodiode having a first area, a first floating diffusion node in which charges generated by the first photodiode are stored, a first charge transfer transistor configured to transfer the charges generated by the first photodiode to the first floating diffusion node, a second photodiode having a second area smaller than the first area, a second floating diffusion node in which charges generated by the second photodiode are stored, and a second charge transfer transistor configured to transfer the charges generated by the second photodiode to the second floating diffusion node, wherein an image signal at a first illuminance is generated using an output signal based on the charges generated by the first photodiode, and an image signal at a second illuminance higher than the first illuminance is generated using an output signal based on the charges generated by the second photodiode.

### BRIEF DESCRIPTION OF THE DRAWINGS

The accompanying drawings, which are included to provide a further understanding of the disclosure and are incorporated in and constitute a part of this application, illustrate embodiments of the disclosure and together with the description serve to explain the principle of the disclosure. In the drawings:
FIG. 1 is a block diagram of an electronic device including an image sensing apparatus according to one embodiment of the present disclosure;
FIG. 2 is a plan view of a pixel array included in an image sensing apparatus according to a first embodiment of the present disclosure;
FIG. 3 is a cross-sectional view taken along line A-A' of the pixel array of FIG. 2;
FIG. 4 is a plan view of a pixel array included in an image sensing apparatus according to a second embodiment of the present disclosure;
FIG. 5 is a cross-sectional view taken along line A-A' of the pixel array of FIG. 4;
FIG. 6 is a circuit diagram of a unit pixel included in the image sensing apparatus according to one embodiment of the present disclosure;
FIG. 7 is a signal timing diagram according to a method of driving the image sensing apparatus according to one embodiment of the present disclosure; and
FIG. 8 is a graph illustrating output signals of the unit pixel according to luminance levels.

### DETAILED DESCRIPTION OF THE DISCLOSURE

Reference will now be made in detail to aspects of the present disclosure, examples of which may be illustrated in the accompanying drawings. The progression of processing steps and/or operations described is an example; however, the sequence of steps and/or operations is not limited to that set forth herein and may be changed as is known in the art, with the exception of steps and/or operations necessarily occurring in a particular order. Names of the respective elements used in the following explanations may be selected only for convenience of writing the specification and may be thus different from those used in actual products.

Advantages and features of the present disclosure, and implementation methods thereof will be clarified through following exemplary aspects described with reference to the accompanying drawings. The present disclosure may, however, be embodied in different forms and should not be construed as limited to the exemplary aspects set forth herein. Rather, these exemplary aspects are provided so that this disclosure will be thorough and complete, and will fully convey the scope of the present disclosure to those skilled in the art. Further, the present disclosure is only defined by scopes of claims.

A shape, a size, a ratio, an angle, and a number disclosed in the drawings for describing exemplary aspects of the present disclosure are merely an example, and thus, the present disclosure is not limited to the illustrated details. Like reference numerals refer to like elements throughout. In the following description, when the detailed description of the relevant known function or configuration is determined to unnecessarily obscure the important point of the present disclosure, the detailed description will be omitted.

In a case where "include, " "have, " "comprise, " "contain, " "constitute, " "make up of, " "formed of, " and "consist of" described in the present specification are used, another part may be added unless 'only~' is used. The terms of a singular form may include plural forms unless referred to the contrary.

In construing an element, the element is construed as including an error range although there is no explicit description.

In describing a position relationship, for example, when a position relation between two parts is described as "on", "above", "over", "below", "under", "beside", "beneath", "near", "close to, " "adjacent to", "on a side of", "next", one or more other parts may be disposed between the two parts unless 'just' or 'direct' is used.

In describing a time relationship, for example, when the temporal order is described as 'after~', 'subsequent~', 'next~', and 'before~', a case which is not continuous may be included unless 'just' or 'direct' is used.

It will be understood that, although the terms "first", "second", etc. may be used herein to describe various elements, these elements should not be limited by these terms. These terms are only used to distinguish one element from another. Accordingly, a first element mentioned hereinafter could be termed a second element without departing from the scope of the present disclosure.

The term "at least one" should be understood as including any and all combinations of one or more of the associated listed items. For example, the meaning of "at least one of a first item, a second item, and a third item" denotes each of the first item, the second item, and the third item as well as the combination of all items proposed from two or more of the first item, the second item, and the third item.

Features of various exemplary aspects of the present disclosure may be partially or overall coupled to or combined with each other and may be variously inter-operated or combined with each other and driven technically as those skilled in the art may sufficiently understand. The exemplary aspects of the present disclosure may be carried out independently from each other, or may be carried out together in co-dependent relationship.

Hereinafter, embodiments of the present specification will be described in detail with reference to the accompanying drawings.

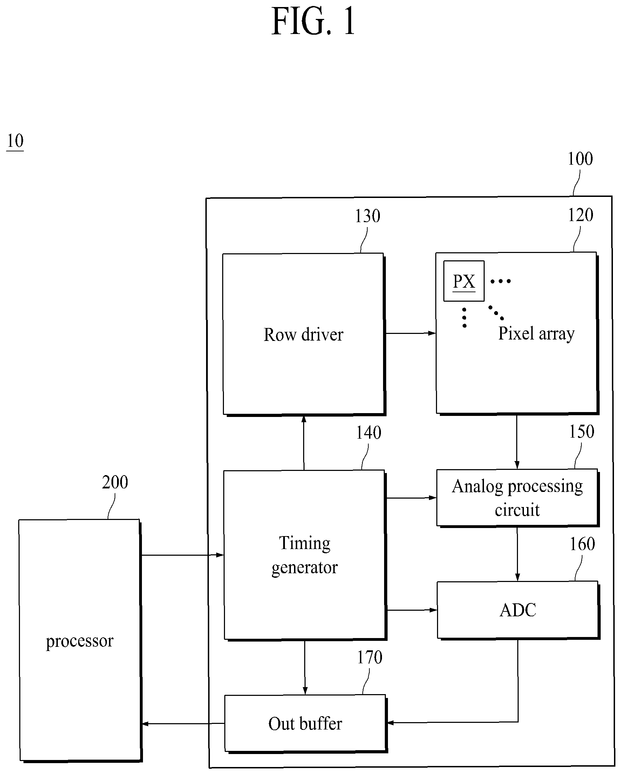

FIG. 1 is a block diagram of an electronic device including an image sensing apparatus according to one embodiment of the present disclosure. As illustrated in FIG. 1, an electronic device 10 according to one embodiment of the present disclosure can include an image sensing apparatus 100 and a processor 200.

The electronic device 10 including the image sensing apparatus 100 according to the present disclosure can include cameras, smartphones, wearable devices, Internet of Things (IoT) devices, home appliances, tablet personal computers (PCs), robots, robot vacuum cleaners, portable multimedia players (PMPs), navigation devices, drones, advanced driver assistance systems (ADAS), and the like. In addition, the electronic device 10 can be an electronic device provided as a component of vehicles, furniture, manufacturing equipment, doors, various measuring instruments, or the like.

The image sensing apparatus 100 emits an optical signal toward an object, converts the optical signal reflected from the object into an electrical signal, and outputs the electrical signal to the processor 200.

As illustrated in FIG. 1, the image sensing apparatus 100 includes a pixel array 120, a row driver 130, a timing generator 140, an analog processing circuit 150, an analog-to-digital converter (ADC) 160, and an output buffer 170.

The pixel array 120 includes a plurality of unit pixels PX. The plurality of unit pixels PX can be arranged in two dimensions. As an example, the plurality of unit pixels PX can be arranged in the form of a matrix composed of M rows (where M is an integer greater than or equal to 2) and N columns (where N is an integer greater than or equal to 2).

In one embodiment, the pixel array 120 can include red pixels that convert light in a red spectrum region into an electrical signal, green pixels that convert light in a green spectrum region into an electrical signal, and blue pixels that convert light in a blue spectrum region into an electrical signal. However, the present disclosure is not limited thereto, and the pixel array 120 can further include white pixels. Alternatively, the pixel array 120 can include pixels according to another color combination, for example, cyan pixels, yellow pixels, green pixels, and magenta pixels.

Each of the unit pixels PX included in the pixel array 120 detects an optical signal using a photoelectric conversion element and converts the optical signal into an electrical signal, which is a pixel signal. In one embodiment, the photoelectric conversion element can be a light-sensing element formed of an organic or inorganic material, such as a photodiode, an organic photo film, a perovskite photodiode, a phototransistor, a photogate, or a pinned photodiode. Hereinafter, for convenience of description, it is assumed that the photoelectric conversion element is a photodiode.

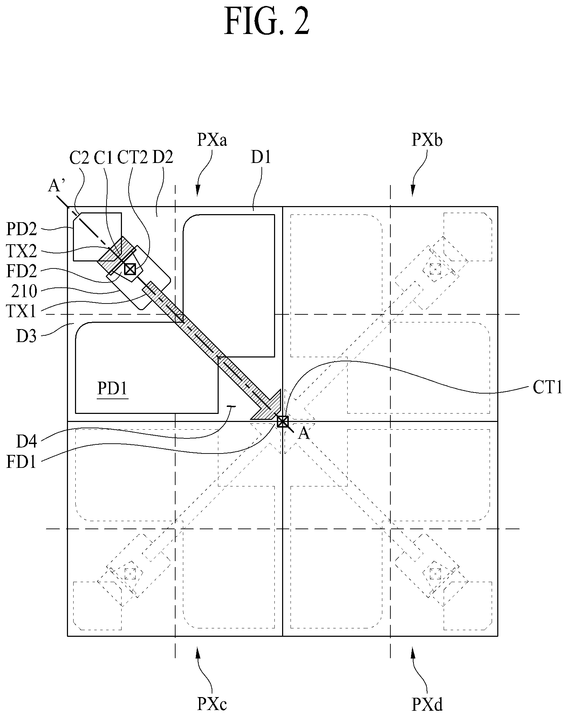

The unit pixel PX according to the present disclosure can include one or more photodiodes. In one embodiment, the unit pixel PX according to the present disclosure can include a first photodiode PD1 and a second photodiode PD2, as illustrated in FIGS. 2 to 4.

In such an embodiment, a light-receiving area of the first photodiode PD1 can be larger than that of the second photodiode PD2. The first photodiode PD1 can be referred to as a large photodiode, and the second photodiode PD2 can be referred to as a small photodiode.

Since the light-receiving area of the first photodiode PD1 is larger, the first photodiode PD1 can generate more charges than the second photodiode PD2 under the same light-receiving conditions. That is, the first photodiode PD1 can have a higher sensitivity than the second photodiode PD2. Based on these characteristics, an output signal based on the charges generated by the first photodiode PD1 can be used to generate an image signal under low illuminance, and an output signal based on the charges generated by the second photodiode PD2 can be used to generate an image signal under high illuminance.

Each unit pixel PX can be driven by control signals received from the row driver 130. In one embodiment, the control signals can include first and second transfer control signals TGS 1 and TGS2, a reset control signal RST, first and second gain control signals DCG1 and DCG2, a connection control signal SW, and a selection signal RS. The signal converted by each unit pixel PX and a reset signal corresponding to a reset component are provided to the analog processing circuit 150.

The row driver 130 drives each unit pixel PX included in the pixel array 120 based on control from the timing generator 140. In one embodiment, the row driver 130 can control all of the unit pixels PX in the pixel array 120 simultaneously, or can control the unit pixels PX in the pixel array 120 on a row-by-row basis. To this end, the row driver 130 can transmit the control signals to the unit pixels PX.

In one embodiment, the row driver 130 can transmit the first and second transfer control signals TGS1 and TGS2, the reset control signal RST, the first and second gain control signals DCG1 and DCG2, the connection control signal SW, and the selection signal RS to each of the unit pixels PX based on control from the timing generator 140.

The timing generator 140 can control the pixel array 120 through the row driver 130 and can output control signals for controlling the analog processing circuit 150, the analog-to-digital converter 160, and the output buffer 170.

The analog processing circuit 150 can sample and hold an output signal provided from the unit pixel PX according to a correlated double sampling (CDS) method, and can perform double sampling of specific noise levels, such as a reset level and a signal level.

The analog processing circuit 150 can generate a comparison result signal corresponding to the reset level and a comparison result signal corresponding to the signal level. Here, a method in which the reset level is read out and then the signal level is read out can be referred to as a complete CDS method, whereas a method in which the signal level is read out and then the reset level is read out can be referred to as an incomplete CDS method or a delta reset sampling (DRS) method.

The analog-to-digital converter 160 can convert output signals output from the analog processing circuit 150 into digital signals and provide the digital signals to the output buffer 170. In FIG. 1, the analog processing circuit 150 and the analog-to-digital converter 160 are illustrated as separate components, but in another embodiment, the analog-to-digital converter 160 can be included in or integrated with the analog processing circuit 150.

The output buffer 170 can latch the digital signals transmitted from the analog-to-digital converter 160 and sequentially output the latched signals.

The processor 200 can process the digital signals output from the output buffer 170 and output the processed digital signals to an external device or store the processed digital signals in a storage device such as a memory. In one embodiment, the external device can be a host processor of the electronic device 10 in which the image sensing apparatus 100 is mounted. For example, the external device can be an application processor of a mobile terminal. The processor 200 can transmit the digital signals to the external device according to a data communication method based on a predetermined interface, for example, a mobile industry processor interface (MIPI). The external device can combine the digital signals transmitted from the processor 200 to generate a high dynamic range (HDR) image.

Hereinafter, the configuration of the pixel array including the unit pixel PX according to the present disclosure will be described in more detail with reference to FIGS. 2 to 5.

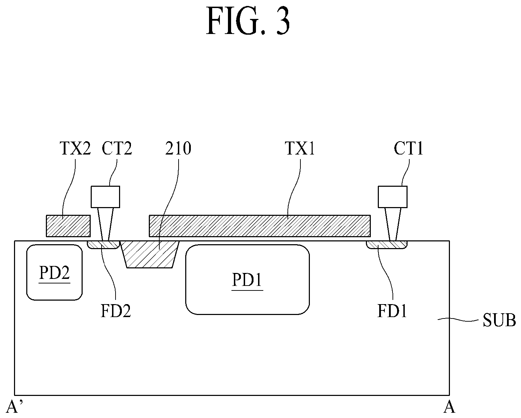

First, a pixel array including a unit pixel according to a first embodiment of the present disclosure will be described with reference to FIGS. 2 and 3. FIG. 2 is a plan view of the pixel array including the unit pixel according to the first embodiment of the present disclosure, and FIG. 3 is a cross-sectional view taken along line A-A' of FIG. 2.

As illustrated in FIG. 2, a pixel array 120 includes a plurality of unit pixels PX, and includes a driving circuit (not shown) for driving the unit pixels PX. In this case, the driving circuit can be disposed for each unit pixel PX, or the plurality of unit pixels PX can share one driving circuit.

The unit pixels PX included in the pixel array 120 can be arranged in a matrix form in an X direction and a Y direction. In FIG. 2, for convenience of description, the pixel array 120 is illustrated as including four unit pixels PXa to PXd, but this is merely an example, and the number of unit pixels PX constituting the pixel array 120 and the arrangement of the unit pixels PX can be variously modified.

Since the four unit pixels PXa to PXd all have similar structures, the following description of the unit pixel PX will be provided based on a structure of one of the four unit pixels for convenience of description, and the reference numeral of the unit pixel will be denoted as PXa.

As illustrated in FIGS. 2 and 3, the unit pixel PXa includes a substrate SUB, a first photodiode PD1, a second photodiode PD2, a first charge transfer transistor TX1, a second charge transfer transistor TX2, a first floating diffusion node FD1, a second floating diffusion node FD2, and an element isolation structure 210.

The substrate SUB can be a silicon substrate or a semiconductor substrate. For example, the substrate SUB can be a silicon substrate or a semiconductor substrate that is not doped with a dopant, a silicon substrate or a semiconductor substrate doped with at least one of an n-type dopant or a p-type dopant, or a silicon substrate or a semiconductor substrate including a well region doped with at least one of an n-type dopant or a p-type dopant.

The first photodiode PD1 can be formed inside the substrate SUB or on a surface of the substrate SUB. The first photodiode PD1 is formed to have a first area within the unit pixel PXa. The first photodiode PD1 has a larger light-receiving area than the second photodiode PD2, and thus can be referred to as a large photodiode.

In one embodiment, as illustrated in FIG. 2, when the unit pixel PXa has a rectangular shape, the first photodiode PD1 can be formed across three quadrants within the unit pixel PXa. For example, as illustrated in FIG. 2, the first photodiode PD1 can be formed across a first quadrant D1, a third quadrant D3, and a fourth quadrant D4 of the unit pixel PXa. That is, the first photodiode PD1 can be formed in regions of the rectangular unit pixel PXa except for a second quadrant D2, and thus can be formed in an overall L-shape."

The first photodiode PD1 is formed to overlap at least a portion of the first charge transfer transistor TX1. In this disclosure, the term "first charge transfer transistor TX1 can be used interchangeably with a gate of the first charge transfer transistor TX1. In such an embodiment, the first charge transfer transistor TX1 is disposed to overlap the first photodiode PD1 at a central portion of the first photodiode PD1, so that the first photodiode PD1 can be formed to have a symmetrical structure with respect to the first charge transfer transistor TX1.

In one embodiment, a portion of the first photodiode PD1 formed in the fourth quadrant D4 can be patterned to expose the substrate SUB. Through this, it is possible to form a region within the fourth quadrant D4 of the unit pixel PXa, in which the first charge transfer transistor TX1 and the first photodiode PD1 do not overlap, thereby minimizing an increase in capacitance caused by the overlap between the first charge transfer transistor TX1 and the first photodiode PD1.

The first photodiode PD1 can be formed by doping a portion of a well region of the substrate SUB. For example, the first photodiode PD1 can be formed within a well region doped with a p-type impurity. However, the present disclosure is not limited thereto, and the first photodiode PD1 can also be formed within a well region doped with an n-type impurity.

In FIG. 2, the first photodiode PD1 is illustrated as having an "L" shape, but the present disclosure is not limited thereto, and the shape of the first photodiode PD1 can be variously modified as long as the first photodiode PD1 has a larger area than the second photodiode PD2.

The second photodiode PD2 can be formed inside the substrate SUB or on the surface of the substrate SUB. The second photodiode PD2 is formed to have a second area smaller than the first area within the unit pixel PXa. The second photodiode PD2 has a smaller light-receiving area than the first photodiode PD1, and thus can be referred to as a small photodiode.

In one embodiment, the second photodiode PD2 can be formed in a rectangular shape. In FIG. 2, the second photodiode PD2 is illustrated as having a rectangular shape, but the present disclosure is not limited thereto, and the shape of the second photodiode PD2 can be variously modified as long as the second photodiode PD2 has a smaller area than the first photodiode PD1.

In one embodiment, two facing corners C1 and C2 of four corners of the second photodiode PD2 can be chamfered. In this case, the chamfered corners of the second photodiode PD2 can include a first corner C1 facing the first photodiode PD1 and a second corner C2 facing the first corner C1 in a diagonal direction.

In the present disclosure, the reason for chamfering the second corner C2 is to ensure a sufficient separation distance from the second photodiodes PD2 of adjacent unit pixels PX, and the reason for chamfering the first corner C1, which faces the second corner C2 in the diagonal direction, is to form the second photodiode PD2 in a symmetrical structure, thereby forming a symmetrical electric field within the second photodiode PD2 and improving electric field uniformity.

In FIG. 3, the second photodiode PD2 is illustrated as being formed to have a shallower depth inside the substrate SUB compared to the first photodiode PD1, but this is merely an example, and the second photodiode PD2 can also be formed within the substrate SUB to have the same depth as the first photodiode PD1.

The second photodiode PD2 can be formed by doping a portion of a well region of the substrate SUB. For example, the second photodiode PD2 can be formed within a well region doped with a p-type impurity. However, the present disclosure is not limited thereto, and the second photodiode PD2 can also be formed within a well region doped with an n-type impurity.

Meanwhile, although not illustrated in the drawings, a microlens configured to collect light incident from the outside can be disposed on the first photodiode PD1 and the second photodiode PD2. In addition, a color filter, a protective layer, an insulating structure, or the like can be interposed between the microlens and the first and second photodiodes PD1 and PD2.

As described above, according to the present disclosure, since both the first photodiode PD1 having the first area and the second photodiode PD2 having the second area smaller than the first area can be formed within one pixel PXa, it is possible to easily realize a dynamic range even when a pixel size in the image sensing apparatus 100 is reduced.

The first charge transfer transistor TX1 couples the first photodiode PD1 to the first floating diffusion node FD1 and transfers charges generated by the first photodiode PD1 to the first floating diffusion node FD1. The first charge transfer transistor TX1 can be turned on or off in response to the first transfer control signal TGS1. When turned on, the first charge transfer transistor TX1 can transfer the charges generated by the first photodiode PD1 to the first floating diffusion node FD1.

In one embodiment, the first charge transfer transistor TX1 is formed to at least partially overlap the first photodiode PD1. Specifically, one end of the first charge transfer transistor TX1 overlaps the element isolation structure 210, and the other end of the first charge transfer transistor TX1 overlaps the first floating diffusion node FD1. Accordingly, the first charge transfer transistor TX1 extends in the diagonal direction from the element isolation structure 210 to the first floating diffusion node FD1.

As described above, in the case of the unit pixel PXa according to the first embodiment of the present disclosure, since the first charge transfer transistor TX1 is formed to at least partially overlap the first photodiode PD1, and in a plan view, an outer periphery of the first photodiode PD1 is exposed without being surrounded by the first charge transfer transistor TX1, doping (or implantation) of a p-type impurity (or an n-type impurity) becomes easier, thereby improving dark current characteristics of the image sensing apparatus 100.

In one embodiment, as illustrated in FIG. 2, the other end of the first charge transfer transistor TX1 can be formed to have a larger area than one end thereof, thereby enabling smoother transfer of charges to the first floating diffusion node FD1.

In the case of the above-described embodiment, the first photodiode PD1 can have a symmetrical structure with respect to the first charge transfer transistor TX1, which is disposed to overlap the first photodiode PD1 in the diagonal direction, so that a symmetrical electric field can be formed within the first photodiode PD1, thereby improving electric field uniformity.

The second charge transfer transistor TX2 couples the second photodiode PD2 to the second floating diffusion node FD2 and transfers charges generated by the second photodiode PD2 to the second floating diffusion node FD2. The second charge transfer transistor TX2 can be turned on or off in response to the second transfer control signal TGS2. When turned on, the second charge transfer transistor TX2 can transfer the charges generated by the second photodiode PD2 to the second floating diffusion node FD2.

In one embodiment, since the second photodiode PD2 is formed in a position adjacent to the second floating diffusion node FD2 within the unit pixel PXa, the second charge transfer transistor TX2 can be formed smaller in size than the first charge transfer transistor TX1.

The first floating diffusion node FD1 stores the charges generated by the first photodiode PD1. Parasitic capacitors (not shown) can be formed on the first floating diffusion nodes FD1. In one embodiment, the first floating diffusion node FD1 can be shared by the first to fourth unit pixels PXa to PXd. The first floating diffusion node FD1 can be electrically coupled to the second floating diffusion node FD2 and the driving circuit via a first contact CT1.

The second floating diffusion node FD2 stores the charges generated by the second photodiode PD2. Parasitic capacitors (not shown) can be formed on the second floating diffusion nodes FD2. In one embodiment, the second floating diffusion node FD2 can be disposed such that at least a portion thereof is surrounded by the element isolation structure 210. The second floating diffusion node FD2 can be electrically coupled to the first floating diffusion node FD1 and the driving circuit via a second contact CT2.

The element isolation structure 210 is disposed between the first photodiode PD1 and the second photodiode PD2 to isolate the first photodiode PD1 from the second photodiode PD2. In one embodiment, the element isolation structure 210 can be formed using shallow trench isolation (STI).

In one embodiment, as illustrated in FIG. 2, the four unit pixels PXa to PXd, which share the first floating diffusion node FD1, can be formed in a symmetrical structure with respect to the first floating diffusion node FD1. Accordingly, the first photodiodes PD1, the second photodiodes PD2, the first charge transfer transistors TX1, and the second charge transfer transistors TX2 of the respective unit pixels PXa to PXd can also be formed in a symmetrical structure with respect to the first floating diffusion node FD1.

As described above, in the present disclosure, since the four unit pixels PXa to PXd are formed in a symmetrical structure with respect to the first floating diffusion node FD1, electric field uniformity can be improved.

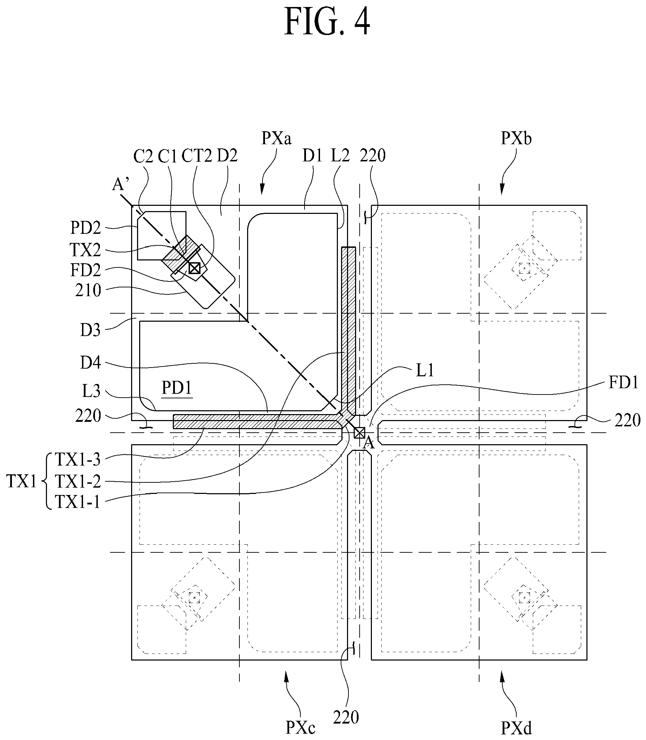

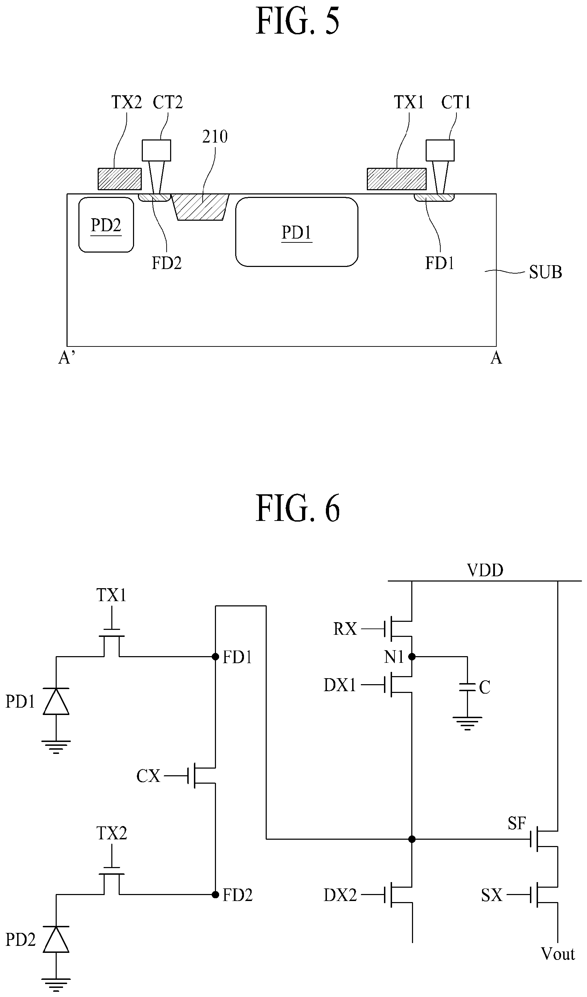

Hereinafter, a pixel array including a unit pixel according to a second embodiment of the present disclosure will be described with reference to FIGS. 4 and 5. FIG. 4 is a plan view of the pixel array including the unit pixel according to the second embodiment of the present disclosure, and FIG. 5 is a cross-sectional view taken along line A-A' of FIG. 4.

As illustrated in FIGS. 4 and 5, a pixel array 120 includes a plurality of unit pixels PXa to PXd that are separated from each other by a pixel isolation structure 220, and a driving circuit (not shown) for driving the unit pixels PXa to PXd. In this case, the driving circuit can be disposed for each of the unit pixels PXa to PXd, or the plurality of unit pixels PXa to PXd can share one driving circuit.

The unit pixels PXa to PXd included in the pixel array 120 can be arranged in a matrix form in the X direction and the Y direction. Unlike the pixel array 120 illustrated in FIG. 2, the pixel array 120 illustrated in FIG. 4 includes the unit pixels PXa to PXd that are separated from each other by the pixel isolation structure 220. Accordingly, a first floating diffusion node FD1 can be formed in a substantially island shape. In one embodiment, the pixel isolation structure 220 can be formed using deep trench isolation (DTI).

In FIG. 4, for convenience of description, the pixel array 120 is illustrated as including four unit pixels PXa to PXd, but this is merely an example, and the number of unit pixels PX constituting the pixel array 120 and the arrangement of the unit pixels PX can be variously modified.

Since the four unit pixels PXa to PXd all have similar structures, the following description of the unit pixel PX will be provided based on a structure of one of the four unit pixels PXa to PXd for convenience of description, and the reference numeral of that unit pixel will be denoted as PXa.

As illustrated in FIGS. 4 and 5, the unit pixel PXa includes a substrate SUB, a first photodiode PD1, a second photodiode PD2, a first charge transfer transistor TX1, a second charge transfer transistor TX2, the first floating diffusion node FD1, a second floating diffusion node FD2, and an element isolation structure 210.

Since the substrate SUB, the second photodiode PD2, the second charge transfer transistor TX2, the first floating diffusion node FD1, and the second floating diffusion node FD2 are the same as those illustrated in FIG. 2, detailed descriptions thereof will be omitted, and the following description will focus on the first photodiode PD1 and the first charge transfer transistor TX1.

The first photodiode PD1 can be formed inside the substrate SUB or on a surface of the substrate SUB. The first photodiode PD1 is formed to have a first area within the unit pixel PXa. The first photodiode PD1 has a larger light-receiving area than the second photodiode PD2, and thus can be referred to as a large photodiode.

In one embodiment, as illustrated in FIG. 4, when the unit pixel PXa has a rectangular shape, the first photodiode PD1 can be formed across three quadrants within the unit pixel PXa. For example, as illustrated in FIG. 4, the first photodiode PD1 can be formed across a first quadrant D1, a third quadrant D3, and a fourth quadrant D4 of the unit pixel PXa. That is, the first photodiode PD1 can be formed in regions of the rectangular unit pixel PXa except for a second quadrant D2, and thus can be formed in an overall L-shape."

In this case, unlike the first photodiode PD1 illustrated in FIG. 2, the first photodiode PD1 illustrated in FIG. 4 is formed without being patterned even within the fourth quadrant D4. Accordingly, the first photodiode PD1 illustrated in FIG. 4 can have a larger light-receiving area compared to the first photodiode PD1 illustrated in FIG. 2.

The first photodiode PD1 is formed so as not to overlap the first charge transfer transistor TX1 within the unit pixel PXa. Accordingly, the size of a capacitor formed between the first charge transfer transistor TX1 and the first photodiode PD1 due to the overlap of the first charge transfer transistor TX1 and the first photodiode PD1 can be reduced. As a result, resistive-capacitive (RC) delay, which can occur due to the capacitor formed between the first charge transfer transistor TX1 and the first photodiode PD1, can be reduced, thereby decreasing a driving load of the unit pixel PXa and improving charge transfer characteristics.

The first photodiode PD1 can be formed by doping a portion of a well region of the substrate SUB. For example, the first photodiode PD1 can be formed within a well region doped with a p-type impurity. However, the present disclosure is not limited thereto, and the first photodiode PD1 can also be formed within a well region doped with an n-type impurity.

In FIG. 4, the first photodiode PD1 is illustrated as having an "L" shape, but the present disclosure is not limited thereto, and the shape of the first photodiode PD1 can be variously modified as long as the first photodiode PD1 has a larger area than the second photodiode PD2.

The first charge transfer transistor TX1 couples the first photodiode PD1 to the first floating diffusion node FD1 and transfers charges generated by the first photodiode PD1 to the first floating diffusion node FD1.

In one embodiment, the first charge transfer transistor TX1 is disposed so as not to overlap the first photodiode PD1 and to face the first photodiode PD1 in a plan view.

More specifically, among sides of the first photodiode PD1, the side on which a corner region that faces the first floating diffusion node FD1 is chamfered is referred to as a first side L1, the side extending in a first direction from one end of the first side L1 is referred to as a second side L2, and the side extending in a second direction perpendicular to the first direction from the other end of the first side L1 is referred to as a third side L3. In this case, the first charge transfer transistor TX1 can include a first gate TX1_1 formed to face the first side L1, a second gate TX1_2 formed to face the second side L2, and a third gateTX1_3 formed to face the third side L3 in a plan view. In this case, the first gate TX1_1, the second gate TX1_2, and the third gate TX1_3 can be integrally formed.

Meanwhile, as illustrated in FIG. 4, the first charge transfer transistor TX1 can be disposed on the pixel isolation structure 220 between the unit pixels PXa to PXd so as to overlap the pixel isolation structure 220. In such an embodiment, since the first charge transfer transistor TX1 is disposed to overlap the pixel isolation structure 220, an overlapping area between the first charge transfer transistor TX1 and an active region of the substrate SUB can be minimized. As a result, an area within the active region of the substrate SUB in which the first photodiode PD1 can be formed can be maximized.

As described above, in the case of the unit pixel PXa according to the second embodiment of the present disclosure, since the first photodiode PD1 and the first charge transfer transistor TX1 do not overlap, the size of a capacitor formed due to the overlap of the first charge transfer transistor TX1 and the first photodiode PD1 and RC delay due thereto can be reduced, thereby improving charge transfer characteristics.

Meanwhile, although not illustrated in FIGS. 2 and 4, the driving circuit according to the present disclosure can include a reset transistor RX, a first conversion gain transistor DX1, a second conversion gain transistor DX2, a connection transistor CX, a driving transistor SF, and a selection transistor SX, as illustrated in FIG. 6. In this case, as illustrated in FIG. 2, the driving circuit can be electrically coupled to the unit pixel PXa via the first contact CT1 coupled to the first floating diffusion node FD1 and the second contact CT2 coupled to the second floating diffusion node FD2.

First, the reset transistor RX is turned on in response to the reset control signal RST received from the row driver 130, thereby resetting potentials of the first and second floating diffusion nodes FD1 and FD2 to a reset voltage VDD.

The first conversion gain transistor DX1 can be coupled between the first floating diffusion node FD1 and the reset transistor RX. A conversion gain represents a ratio at which charges generated by the photodiode PD are converted into an electrical signal (e.g., a pixel voltage). The conversion gain can vary depending on a capacitance of a capacitor (or a parasitic capacitor) coupled to the floating diffusion node.

The first conversion gain transistor DX1 can be turned on or off in response to the first gain control signal DCG1 and, when turned on, can couple a capacitor C to the first floating diffusion node FD1. When the first floating diffusion node FD1 is coupled to the capacitor C, a capacitance of the first floating diffusion node FD1 increases, and a conversion gain can decrease. When the first conversion gain transistor DX1 is turned on and the capacitor C is coupled to the first floating diffusion node FD1, the unit pixel PXa can operate in a lateral overflow integration capacitor (LOFIC) mode, in which the conversion gain is minimized.

The second conversion gain transistor DX2 can be coupled between the first floating diffusion node FD1 and the ground. The second conversion gain transistor DX2 can be turned on or off in response to the second gain control signal DCG2 and, when turned on, can couple a parasitic capacitor of the second conversion gain transistor DX2 to the first floating diffusion node FD1. When the second conversion gain transistor DX2 is turned on in a state in which the connection transistor CX is turned on such that the first and second floating diffusion nodes FD1 and FD2 are coupled to each other, the parasitic capacitor of the second conversion gain transistor DX2 is coupled to the first and second floating diffusion nodes FD1 and FD2. Accordingly, the pixel PXa can operate in a low conversion gain (LCG) mode, in which the conversion gain is higher than that in the LOFIC mode.

The connection transistor CX is turned on in response to the connection control signal SW received from the row driver 130, thereby coupling the first and second floating diffusion nodes FD1 and FD2. By turning on the first charge transfer transistor TX1, the pixel PXa operates in a high conversion gain (HCG) mode in which the conversion gain is the highest, and subsequently, by turning on the connection transistor CX, the second floating diffusion node FD2 is coupled to the first floating diffusion node FD1, thereby increasing the capacitance and allowing the pixel PXa to operate in the LCG mode.

The driving transistor SF outputs a current corresponding to the potential of the first floating diffusion node FD1 as a reset signal or a pixel signal through the selection transistor SX.

The selection transistor SX is turned on in response to the selection signal RS received from the row driver 130, thereby outputting the reset signal or the pixel signal output from the driving transistor SF as an output signal Vout.

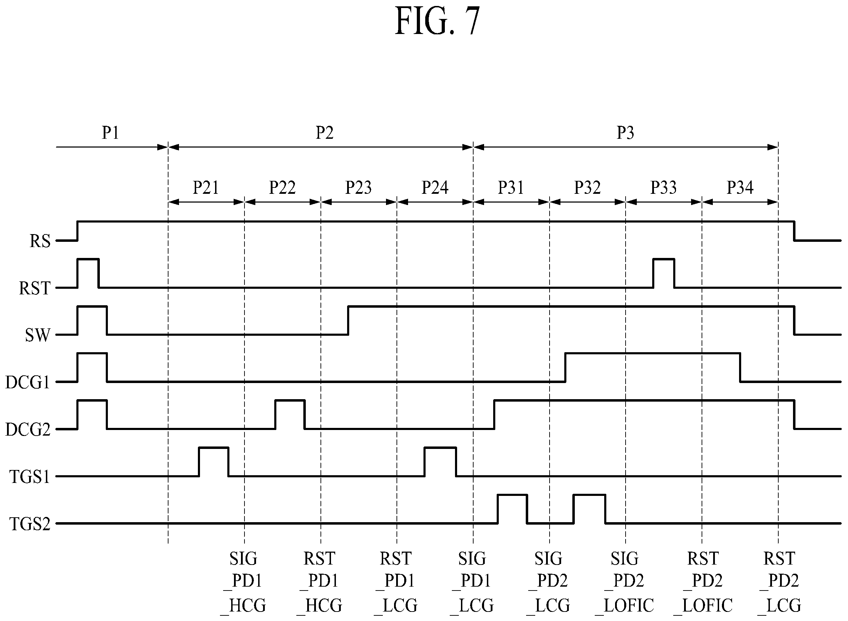

Hereinafter, a method of operating the image sensing apparatus according to the present disclosure will be described with reference to FIG. 7. FIG. 7 is a signal timing diagram according to the method of driving the image sensing apparatus according to one embodiment of the present disclosure.

First, in FIG. 7, it is assumed that an active level of each of the control signals is a logic high (first level), and an inactive level is a logic low (second level).

The selection transistor SX is turned on in response to the selection signal RS being at the logic high during a readout period of the unit pixel PX. Accordingly, the unit pixel PX is coupled to a column line (not shown) so that the unit pixel PX can be read out. The readout period of the unit pixel PX can include a first period P1 in which the unit pixel PX is reset, a second period P2 in which the first photodiode PD1 is read out, and a third period P3 in which the second photodiode PD2 is read out.

In the first period P1, the reset transistor RX, the connection transistor CX, and the first and second conversion gain transistors DX1 and DX2 are turned on, so that a predetermined reset voltage VDD is applied to the first and second floating diffusion nodes FD1 and FD2, thereby resetting a potential of the unit pixel PX to the level of the reset voltage VDD.

The second period P2 can include first to fourth sub-periods P21, P22, P23, and P24.

In the first sub-period P21 and the second sub-period P22, the unit pixel PX can operate in an HCG mode based on the first photodiode PD1.

Specifically, in the first sub-period P21, the first charge transfer transistor TX1 is turned on in response to the first transfer control signal TGS1 being at the active level, so that charges generated by the first photodiode PD1 are stored in the first floating diffusion node FD1. A voltage level corresponding to the charges stored in the first floating diffusion node FD1 is output as the output signal Vout through the driving transistor SF and the selection transistor SX. At this time, the output signal Vout is a high-sensitivity signal SIG_PD1_HCG, which can be used to form an image corresponding to high sensitivity for obtaining an HDR image.

In the second sub-period P22, the first charge transfer transistor TX1 is turned off in response to the first transfer control signal TGS1 being at the inactive level, and the second conversion gain transistor DX2 is turned on by the second gain control signal DCG2 at the active level. Since the selection transistor SX remains turned on, a voltage level corresponding to a reset component of the first floating diffusion node FD1 is output as the output signal Vout through the driving transistor SF and the selection transistor SX. At this time, the output signal is a high-sensitivity reset signal RST_PD1_HCG, which can be used to form an image corresponding to high sensitivity for obtaining an HDR image. That is, a signal corresponding to actual charges under high-sensitivity conditions can be obtained through correlated double sampling (CDS) of the high-sensitivity signal SIG_PD1_HCG obtained in the first sub-period P21 and the high-sensitivity reset signal RST_PD1_HCG obtained in the second sub-period P22.

In the third sub-period P23 and the fourth sub-period P24, the unit pixel PX can operate in an LCG mode based on the first photodiode PD1.

In the third sub-period P23, the connection transistor CX is turned on by the connection control signal SW at the active level, thereby coupling the second floating diffusion node FD2 to the first floating diffusion node FD1. As a result, the capacitance of the first floating diffusion node FD1 increases, thereby reducing the conversion gain. A voltage level corresponding to a reset component of the first and second floating diffusion nodes FD1 and FD2 is output as the output signal Vout through the driving transistor SF and the selection transistor SX. At this time, the output signal is a first low-sensitivity reset signal RST_PD1_LCG, which can be used to form an image corresponding to a first low-sensitivity for obtaining an HDR image.

In the fourth sub-period P24, the first charge transfer transistor TX1 is turned on by the first transfer control signal TGS1 at the active level, and the connection transistor CX is turned on by the connection control signal SW at the active level, thereby coupling the second floating diffusion node FD2 to the first floating diffusion node FD1. As a result, a voltage level generated by the first photodiode PD1 and stored in the first and second floating diffusion nodes FD1 and FD2 is output as the output signal Vout through the driving transistor SF and the selection transistor SX. At this time, the output signal is a first low-sensitivity signal SIG_PD1_LCG, which can be used to form an image corresponding to the first low-sensitivity for obtaining an HDR image. That is, a signal corresponding to actual charges under low-sensitivity conditions can be obtained through correlated double sampling (CDS) of the first low-sensitivity reset signal RST_PD1_LCG obtained in the third sub-period P23 and the first low-sensitivity signal SIG_PD1_LCG obtained in the fourth sub-period P24.

The third period P3 can include first to fourth sub-periods P31, P32, P33, and P34.

In the first sub-period P31, the second charge transfer transistor TX2 is turned on in response to the second transfer control signal TGS2 being at the active level, the connection transistor CX is turned on by the connection control signal SW at the active level, thereby coupling the second floating diffusion node FD2 to the first floating diffusion node FD1, and the second conversion gain transistor DX2 is turned on by the second gain control signal DCG2 at the active level. Accordingly, a voltage level generated by the second photodiode PD2 and stored in the first and second floating diffusion nodes FD1 and FD2 is output as the output signal Vout through the driving transistor SF and the selection transistor SX. At this time, the output signal is a second low-sensitivity signal SIG_PD2_LCG, which can be used to form an image corresponding to a second low-sensitivity for obtaining an HDR image.

In the second sub-period P32, the second charge transfer transistor TX2 is turned on in response to the second transfer control signal TGS2 being at the active level, and the connection transistor CX is turned on by the connection control signal SW at the active level, thereby coupling the second floating diffusion node FD2 to the first floating diffusion node FD1. The second conversion gain transistor DX2 is turned on by the second gain control signal DCG2 at the active level, and the first conversion gain transistor DX1 is turned on by the first gain control signal DCG1 at the active level, thereby coupling the capacitor C to the first and second floating diffusion nodes FD1 and FD2. As a result, the capacitance of the first and second floating diffusion nodes FD1 and FD2 increases, thereby further reducing the conversion gain. Accordingly, a voltage level generated by the second photodiode PD2 and stored in the first and second floating diffusion nodes FD1 and FD2 and the capacitor C is output as the output signal Vout through the driving transistor SF and the selection transistor SX. At this time, the output signal is an ultra-low-sensitivity signal SIG_PD2_LOFIC, which can be used to form an image corresponding to ultra-low-sensitivity for obtaining an HDR image.

In the third sub-period P33, the second charge transfer transistor TX2 is turned off by the second transfer control signal TGS2 at the inactive level, and the connection transistor CX is turned on by the connection control signal SW at the active level, thereby coupling the second floating diffusion node FD2 to the first floating diffusion node FD1. The second conversion gain transistor DX2 is turned on by the second gain control signal DCG2 at the active level, the first conversion gain transistor DX1 is turned on by the first gain control signal DCG1 at the active level, and the reset transistor RX is turned on by the reset control signal RST at the active level. Accordingly, the reset voltage VDD is applied to the first and second floating diffusion nodes FD1 and FD2 and the capacitor C. A voltage level corresponding to a reset component of the first and second floating diffusion nodes FD1 and FD2 and the capacitor C is output as the output signal Vout through the driving transistor SF and the selection transistor SX. At this time, the output signal is an ultra-low-sensitivity reset signal RST_PD2_LOFIC, which can be used to form an image corresponding to ultra-low-sensitivity for obtaining an HDR image. That is, a signal corresponding to actual charges under ultra-low-sensitivity conditions can be obtained through correlated double sampling (CDS) of the ultra-low-sensitivity signal SIG_PD2_LOFIC obtained in the second sub-period P32 and the ultra-low-sensitivity reset signal RST_PD2_LOFIC obtained in the third sub-period P33.

In the fourth sub-period P34, the connection transistor CX is turned on by the connection control signal SW at the active level, thereby coupling the second floating diffusion node FD2 to the first floating diffusion node FD1. The second conversion gain transistor DX2 is turned on by the second gain control signal DCG2 at the active level, and the first conversion gain transistor DX1 is turned off by the first gain control signal DCG1 at the inactive level. Accordingly, a voltage level corresponding to a reset component of the first and second floating diffusion nodes FD1 and FD2 is output as the output signal Vout through the driving transistor SF and the selection transistor SX. At this time, the output signal is a second low-sensitivity reset signal RST_PD2_LCG, which can be used to form an image corresponding to the second low-sensitivity for obtaining an HDR image. That is, a signal corresponding to actual charges under low-sensitivity conditions can be obtained through correlated double sampling (CDS) of the second low-sensitivity signal SIG_PD2_LCG obtained in the first sub-period P31 and the second low-sensitivity reset signal RST_PD2_LCG obtained in the fourth sub-period P34.

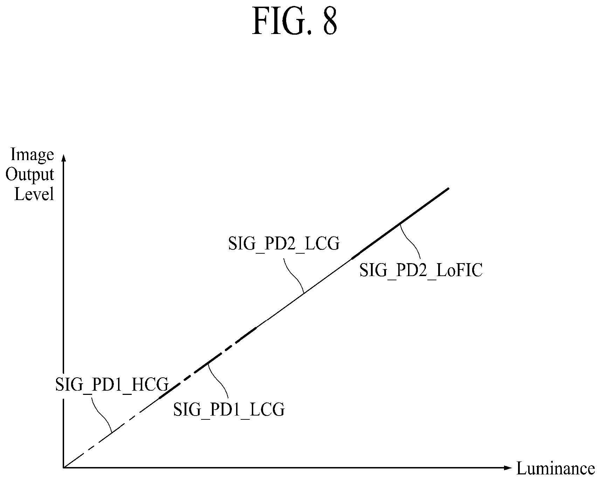

FIG. 8 is a graph illustrating output signals of the unit pixel according to luminance levels.

As illustrated in FIG. 8, the high-sensitivity signal SIG_PD1_HCG can constitute a high-sensitivity image, the first low-sensitivity signal SIG_PD1_LCG and the second low-sensitivity signal SIG_PD2_LCG can constitute a low-sensitivity image, and the ultra-low-sensitivity signal SIG_PD2_LOFIC can constitute an ultra-low-sensitivity image.

At this time, the high-sensitivity signal SIG_PD1_HCG and the first low-sensitivity signal SIG_PD1_LCG, which are based on the charges generated by the first photodiode PD1, can constitute a low-illuminance image, and the second low-sensitivity signal SIG_PD2_LCG and the ultra-low-sensitivity signal SIG_PD2_LOFIC, which are based on the charges generated by the second photodiode PD2, can constitute a high-illuminance image.

An HDR image can be generated by synthesizing the high-sensitivity image, the low-sensitivity image, and the ultra-low-sensitivity image.

According to the present disclosure, since both a first photodiode having a first area and a second photodiode having a second area smaller than the first area can be formed within a single pixel, a dynamic range can be easily realized even when a pixel size in an image sensing apparatus is reduced.

Further, according to the present disclosure, dark current characteristics of an image sensing apparatus can be improved by allowing at least a portion of a first charge transfer transistor, which transfers charges generated by a first photodiode to a first floating diffusion node, to overlap the first photodiode.

Further, according to the present disclosure, charge transfer characteristics can be improved by forming a first charge transfer transistor to face a first photodiode and partially surround the first photodiode in a plan view.

It will be apparent to those skilled in the art that various modifications and variations can be made in the present disclosure without departing from the spirit or scope of the disclosures. Thus, it is intended that the present disclosure covers the modifications and variations of this disclosure.

In addition, the methods described in the present disclosure can be implemented, at least in part, using one or more computer programs or components. The components can be provided, as a series of computer instructions, on a computer-readable medium or machine-readable medium, which can include both volatile and non-volatile memory. The instructions can be provided as software or firmware, and can be implemented, in whole or in part, in hardware configurations such as ASICs, FPGAs, DSPs, or other similar devices. The instructions can be configured to be executed by one or more processors or other hardware configurations. The processors or other hardware configurations, when executing the series of computer instructions, can perform or can be configured to perform all or a portion of the methods and procedures disclosed herein.

The various embodiments described above can be combined to provide further embodiments. These and other changes can be made to the embodiments in light of the above-detailed description. In general, in the following claims, the terms used should not be construed to limit the claims to the specific embodiments disclosed in the specification and the claims, but should be construed to include all possible embodiments along with the full scope of equivalents to which such claims are entitled. Accordingly, the claims are not limited by the disclosure.

## Claims

1. An image sensing apparatus comprising:
a first photodiode having a first area;
a first floating diffusion node in which charges generated by the first photodiode are stored;
a first charge transfer transistor configured to transfer the charges generated by the first photodiode to the first floating diffusion node;
a second photodiode having a second area smaller than the first area;
a second floating diffusion node in which charges generated by the second photodiode are stored; and
a second charge transfer transistor configured to transfer the charges generated by the second photodiode to the second floating diffusion node,
wherein an image signal at a first illuminance is generated using an output signal based on the charges generated by the first photodiode, and
an image signal at a second illuminance higher than the first illuminance is generated using an output signal based on the charges generated by the second photodiode.

2. The image sensing apparatus of claim 1, wherein the first charge transfer transistor is formed to at least partially overlap the first photodiode, and
the first photodiode is formed in a symmetrical structure with respect to the first charge transfer transistor.

3. The image sensing apparatus of claim 1 or 2, further comprising an element isolation structure formed between the first photodiode and the second photodiode to separate the first and second photodiodes,
wherein one end of the first charge transfer transistor overlaps the element isolation structure, and the other end of the first charge transfer transistor overlaps the first floating diffusion node, such that the first charge transfer transistor extends in a diagonal direction from the element isolation structure to the first floating diffusion node.

4. The image sensing apparatus of claim 3, wherein the other end of the first charge transfer transistor has a larger area than the one end thereof.

5. The image sensing apparatus of any one of the preceding claims, wherein the first floating diffusion node is shared by a plurality of unit pixels, and
the first photodiodes, the second photodiodes, the first charge transfer transistors, and the second charge transfer transistors of the unit pixels sharing the first floating diffusion node are symmetrically disposed with respect to the first floating diffusion node.

6. The image sensing apparatus of claim 5, wherein each of the unit pixels has a rectangular shape,
the first photodiode is formed in three quadrants within the unit pixel, and
a portion of the first photodiode formed in the quadrant closest to the first floating diffusion node among the three quadrants is patterned to expose a substrate.

7. The image sensing apparatus of any one of the preceding claims, wherein an outer periphery of the first photodiode is exposed without being surrounded by the first charge transfer transistor.

8. The image sensing apparatus of any one of the preceding claims, wherein the second photodiode has a rectangular shape, and
a first corner and a second corner, which face each other among four corners of the second photodiode, are chamfered.

9. The image sensing apparatus of claim 1, wherein the first charge transfer transistor does not overlap the first photodiode, and is disposed to face the first photodiode in a plan view.

10. The image sensing apparatus of claim 9, wherein the first photodiode includes a first side formed with a chamfered corner region facing the first floating diffusion node, a second side extending in a first direction from one end of the first side, and a third side extending in a second direction perpendicular to the first direction from the other end of the first side,
the first charge transfer transistor includes a first gate formed to face the first side, a second gate formed to face the second side, and a third gate formed to face the third side in a plan view, and
the first gate, the second gate, and the third gate are integrally formed.

11. The image sensing apparatus of claim 9 or 10, wherein the first floating diffusion node is shared by a plurality of unit pixels,
the image sensing apparatus further comprises a pixel isolation structure disposed between the unit pixels to separate the unit pixels, and
the first charge transfer transistor is disposed on the pixel isolation structure to overlap the pixel isolation structure.

12. The image sensing apparatus of any one of claims 9 to 11, wherein the first floating diffusion node is disposed in an island shape in a region between the plurality of unit pixels, by the pixel isolation structure, and
the first floating diffusion node is surrounded by the first charge transfer transistor of each of the unit pixels.

13. The image sensing apparatus of any one of the preceding claims, wherein a size of the second charge transfer transistor is smaller than a size of the first charge transfer transistor.

14. The image sensing apparatus of any one of the preceding claims, further comprising:
a connection transistor configured to electrically couple the first floating diffusion node and the second floating diffusion node when turned on in response to a connection control signal;
a capacitor selectively coupled to the first floating diffusion node to increase a capacitance of the first floating diffusion node; and
a conversion gain transistor configured to couple the capacitor to the first floating diffusion node when turned on in response to a gain control signal.

15. The image sensing apparatus of claim 14, wherein a first signal corresponding to the charges generated by the first photodiode and stored in the first floating diffusion node, a second signal corresponding to the charges generated by the first photodiode and stored in the first and second floating diffusion nodes, a third signal corresponding to the charges generated by the second photodiode and stored in the first and second floating diffusion nodes, and a fourth signal corresponding to the charges generated by the second photodiode and stored in the first and second floating diffusion nodes and the capacitor are synthesized into a dynamic range image.
